# FASCICULE DE BREVET EUROPEEN

(11) **EP 3 615 703 B1**
(45) Date de publication et mention de la délivrance du brevet: **17.04.2024**
(21) Numéro de dépôt: 18726525.1
(22) Date de dépôt: 27.04.2018
(51) Int. Cl.: C23C 14/00, C23C 14/06, C23C 14/34, H01J 37/34, C03C 17/00, B22F 5/10, C03C 17/245, C22C 1/10, C22C 29/12, C22C 32/00, C03C 17/34, C22C 26/00, C04B 38/00

(54) **CIBLE POUR L'OBTENTION D'UN VITRAGE COLORE**
ZIEL ZUR ERZEUGUNG EINER FARBIGEN VERGLASUNG
TARGET FOR OBTAINING COLOURED GLAZING

(30) Priorité: 28.04.2017 FR 1753800
(43) Date de publication de la demande: 04.03.2020
(73) Titulaire: Saint-Gobain Coating Solutions, 84093 Avignon Cedex 9 (FR)
(72) Inventeur: MAGDENKO-SAVOUREY, Liubov, 78180 Montigny Le Bretonneux (FR); BILLIERES, Dominique, 84450 Saint-Saturnin Les Avignon (FR); MATEUS, Crisalia, 84140 Montfavet (FR); MARLIN, Samuel, 13750 Plan D'Orgon (FR)
(74) Mandataire: Saint-Gobain Recherche
(86) Numéro de dépôt international: PCT/FR2018/051077
(87) Numéro de publication internationale: WO 2018/197823

(56) Documents cités:
- WO-A1-2015/079286
- DE-A1- 19 958 424
- JP-A- H0 797 226
- JP-A- 2006 144 052
- JP-A- 2015 502 452
- US-A- 5 942 331
- US-A1- 2011 278 511
- BORGES J ET AL: "Thin films composed of Ag nanoclusters dispersed in TiO2: Influence of composition and thermal annealing on the microstructure and physical responses", APPLIED SURFACE SCIENCE, ELSEVIER, AMSTERDAM, NL, vol. 358, 20 août 2015 (2015-08-20), pages 595-604, XP029325785, ISSN: 0169-4332, DOI: 10.1016/J.APSUSC.2015.08.148

## Description

La présente invention se rapporte à une cible permettant notamment de déposer un revêtement conférant à un support verrier une coloration adaptée, sans avoir à ajouter dans la composition initiale du verre des oxydes métalliques supplémentaires. D'une manière générale, ledit traitement vise à modifier l'aspect de surface d'un vitrage, notamment d'un verre plat incolore issu d'un procédé industriel du type verre float, pour lui conférer une coloration après sa mise en forme, par le simple dépôt d'un revêtement en couche mince à partir de ladite cible, ledit revêtement étant constitué dans un matériau présentant un pic d'absorption plasmonique dans le domaine du visible.

Dans le domaine des vitrages pour bâtiments, de nombreuses recherches sont consacrées au développement de vitrages innovants et aux propriétés variées : vitrages pour le contrôle solaire, vitrages autonettoyants ou autres. De plus en plus, on recherche également des vitrages combinant plusieurs propriétés, et notamment des vitrages colorés ayant une ou plusieurs fonctionnalités comme le contrôle solaire, l'isolation thermique (vitrages bas-émissifs), le blindage électromagnétique, le chauffage, les fonctions hydrophile ou hydrophobe, le photocatalytique (vitrages autonettoyants), la modification du niveau de réflexion dans le visible (vitrages anti-reflets ou miroirs).

Lorsque l'on souhaite obtenir des verres colorés présentant éventuellement une fonctionnalité spécifique, le procédé industriel actuel consiste à ajouter des pigments (généralement des oxydes métalliques) dans le bain de fusion du verre float. Au moment de la fabrication du verre, des oxydes métalliques variés peuvent ainsi être utilisés suivant la couleur finale souhaitée du vitrage: CuO pour une coloration rouge, MnO pour du violet ou encore CoO pour du bleu. On obtient ainsi des verres colorés dans leur masse.

Bien que ce procédé soit relativement simple à mettre en oeuvre, il présente un inconvénient majeur. L'utilisation de pigments au moment de l'élaboration du verre contamine le bain de fusion et implique que l'on doive fabriquer une couleur adaptée dans un bain spécifique.

En particulier, un changement de couleur nécessite toujours la fabrication d'un verre de transition : une quantité importante de verre est ainsi perdue jusqu'à l'obtention de la coloration voulue. Ceci implique une perte importante au niveau de la production, ainsi que de la productivité de l'installation, avec au final une augmentation sensible du coût du vitrage si l'on souhaite en modifier la coloration. Ce procédé manque donc de flexibilité pour s'adapter à une demande en perpétuel changement de la part des clients.

Une solution avantageuse permettant d'augmenter la flexibilité dans la production de tels verres colorés consisterait à y déposer un revêtement consistant ou comprenant une couche colorée, les caractéristiques colorimétriques dudit revêtement devant être dans ce cas facilement ajustables et modifiables.

Selon une première méthode connue pour obtenir un tel revêtement, on utilise un procédé sol-gel de polymérisation d'un alcoxyde métallique en présence de particules métalliques d'argent ou d'un autre métal précieux. Ce procédé est cependant coûteux et il est impossible par celui-ci de déposer des couches homogènes de quelques nanomètres ou de quelques dizaines de nanomètres sur des substrats verriers de grande taille comme des PLF, c'est-à-dire typiquement de taille « jumbo » (6000 mm × 3210 mm).

De façon connue, le revêtement d'un substrat par une ou plusieurs couches minces d'un matériau déterminé peut également être effectué en phase vapeur selon plusieurs techniques différentes :
Selon une première méthode dite de pyrolyse, les précurseurs des produits à déposer, apportés sous forme gaz, liquide ou solide sont décomposés sur le substrat chaud (T > 500°C). Dans le cas de précurseurs gazeux, on désigne la méthode sous le terme AP-CVD (Atmospheric Pressure Chemical Vapor Déposition) ou plus généralement CVD thermique. La présente invention ne se rapporte pas à de tels procédés.

Selon un second procédé auquel s'applique la présente invention, on utilise les procédés dits de pulvérisation cathodique ou encore « pulvérisation magnétron » qui consistent à effectuer, dans un vide secondaire et sous champ magnétique, le dépôt par pulvérisation d'une cible du matériau ou d'un précurseur du matériau à déposer. Un exemple de réalisation d'un tel dispositif est par exemple décrit dans le brevet US 6,214,183.

Les procédés de pulvérisation magnétron d'une cible nécessitent une mise en oeuvre dans une installation sous vide muni d'une cible de composition prédéterminée et présente de ce fait, pris individuellement, une flexibilité très restreinte.

Selon un premier aspect, grâce à la mise en oeuvre de la cible selon la présente invention, il devient possible de proposer un procédé simple permettant de déposer un revêtement dont la colorimétrie est facilement ajustable.

Plus particulièrement, un des objectif de la présente invention est de remédier aux problèmes précédemment exposés en proposant une cible permettant la mise en oeuvre d'un procédé de fabrication modulable et qui permette une adaptation flexible et rapide de la colorimétrie recherchée pour le vitrage, ledit procédé étant par ailleurs économique et n'entraînant pas de perte sensible de la production de verre float.

La mise en oeuvre d'une cible selon la présente invention présente plusieurs avantages. Tout d'abord, elle permet de réaliser un vitrage dont la coloration se fait de façon totalement indépendante de la fabrication du verre, en particulier pour un verre incolore. Ainsi, on peut fabriquer du verre sans devoir prévoir à l'avance sa coloration. Les couches minces permettent aussi d'obtenir des verres colorés en faible quantité ; le procédé permis par la présent cible est ainsi beaucoup plus adaptable à la demande et flexible.

Grâce à la cible selon la présente invention, Il devient donc possible d'élaborer des couches de différentes couleurs et en différentes proportions et ceci sans perte intermédiaire de grandes quantités de verre.

On connaît des procédés de dépôts permettant de réaliser des empilements de couches constituées principalement de nanoparticules métalliques et de couches diélectriques, par les techniques dites de pulvérisation magnétron sous vide d'une cible. Par exemple, la publication « Préparation and optical characterization of Au/SiO2 composite films with multilayer structure, H. B. Liao, Weijia Wen, G. K. L. Wong, Journal of Applied Physics, 2003, Vol. n°93, 4485 » décrit la fabrication d'un empilement SiO₂/Au absorbant une longueur d'onde située autour de 530 nm et présentant une couleur rouge en transmission.

La demande WO2010/106370 décrit une méthode pour déposer un revêtement sur un substrat, dans laquelle une solution d'un précurseur est déposée par CVD, AP-CVD ou encore pyrolyse sur un substrat porté à 330-370°C, pour l'obtention d'un film matriciel d'oxyde d'étain, de titane ou de zinc dopé à l'aluminium dans lequel sont intégrée des nanoparticules d'or. Un tel procédé n'apparaît pas assez flexible ni adapté pour une application à l'échelle industrielle, notamment pour la coloration du verre de grande dimension sur des substrats verriers plats issu d'un procédé float dont la largeur est souvent de l'ordre de plusieurs mètres comme expliqué précédemment.

La demande de brevet EP 2221394 A1 décrit une cible de pulvérisation cathodique comprenant comme composants Ti, Ag et O selon une composition (TiO₂₋ₘ)₁₋ₙAgₙ avec m compris entre 0 et 0,5 et n compris entre 0,01 et 0,2.

Les publications JP2006144052, WO 2015/079286 et JP2015502452 décrivent des cibles similaires de TiOx dopée avec un Métal, mais avec un rapport M/Me>0.9.

La présente invention se rapporte à une cible de pulvérisation notamment utile pour l'obtention de couches colorées et présentant un pic d'absorption plasmonique.

Plus précisément, la présente invention se rapporte à une cible de pulvérisation cathodique faite dans un oxyde d'au moins un élément choisi dans le groupe du titane, du silicium, du zirconium et des particules d'un métal compris dans le groupe constitué par l'argent, l'or, le platine, le cuivre et le nickel ou des particules d'un alliage constitué d'au moins deux de ces métaux, le rapport atomique MIMe dans ladite cible étant inférieur à 0,9 avec M représentant l'ensemble des atomes des éléments du groupe du titane, du silicium, du zirconium et Me représentant l'ensemble des atomes des métaux du groupe constitué par l'argent, l'or, le platine, le cuivre et le nickel.
Selon certains aspects préférés de la cible selon la présente invention, qui peuvent être le cas échéant combinés entre eux :
- Le rapport atomique MIMe est inférieur à 0,9, de préférence encore inférieur à 0,8, voire encore inférieur à 0,7 ou même inférieur à 0,6.
- Ledit oxyde est unique.
- Le métal est l'argent.
- Ledit oxyde est un oxyde de titane de formule TiOₓ, avec x ≤2, en particulier un oxyde de titane de formule TiOₓ, avec x <2 et de préférence encore dans laquelle 1,70< x <2,0.
- Selon un mode particulièrement avantageux, la cible selon l'invention est faite dans un mélange d'oxyde de titane et de particules d'argent, le rapport atomique Ti/Ag dans ladite cible étant inférieur à 0.9 et de manière très préférée inférieure à 0,8 ou même inférieur à 0,6.
- Le métal est l'argent, l'or ou le platine, le cuivre ou le nickel, de préférence encore le métal est l'argent, l'or ou le platine et de manière très préférée est l'argent.
- La cible est faite dans un mélange d'oxyde de titane et de particules d'argent, le rapport atomique Ti/Ag dans ladite cible étant inférieur à 0,9 et de manière très préférée inférieure à 0,8 ou même inférieur à 0,6.
- La résistivité électrique, telle que mesurée selon la norme ASTM F76) est inférieure à 5 Ω.cm.
- La porosité est inférieure à 10%.
- La répartition de Me par rapport à M est telle que la différence D entre la teneur mesurée dans ladite cible en phase Me maximale et la teneur mesurée dans ladite cible en phase Me minimale, sur une pluralité de zones d'analyse de même surface 70×70 µm², est inférieure à 50%, de préférence inférieure à 40%, de la teneur moyenne en phase Me mesurée sur ladite cible.
- L'écart-type global calculé sur le nombre total de mesures est inférieur à 25% de la teneur moyenne en phase Me mesurée sur ladite cible.

Ledit oxyde de métal M peut avantageusement être un oxyde sous-stoechiométrique en oxygène, pour les éléments M pour lesquels la résistivité électrique de l'oxyde sous-stoechiométrique est inférieure à celle de l'oxyde stoechiométrique. La sous-stoechiométrie de M pouvant être dans une proportion pouvant aller jusqu'à 15%, préférentiellement jusqu'à 10% afin de limiter l'apport d'oxygène nécessaire ensuite dans le magnétron lors de l'utilisation de la cible.

L'utilisation de la cible selon l'invention permet notamment l'obtention d'un vitrage via la mise en oeuvre par exemple des procédés décrits ci-après, c'est-à-dire permettant le dépôt d'un revêtement à partir de ladite cible, dont la colorimétrie est facilement ajustable. Selon un aspect principal, l'objet de la présente invention permet l'obtention un vitrage comprenant à sa surface une couche en modifiant sa coloration, les caractéristiques de cette couche étant facilement adaptables, de manière au final à conférer audit vitrage la colorimétrie désirée.

Plus particulièrement, un des objectifs de la présente invention est de remédier aux problèmes précédemment exposés en proposant un procédé de fabrication modulable utilisant la cible selon l'invention et qui permette une adaptation flexible et rapide de la colorimétrie recherchée pour le vitrage, ledit procédé étant par ailleurs économique et n'entraînant pas de perte sensible de la production de verre float.

On décrit par la suite un vitrage obtenu par un procédé utilisant une cible selon l'invention et comprenant le dépôt sur un substrat verrier en principe initialement non coloré (souvent appelé dans le métier verre clair) d'un revêtement lui conférant une couleur adaptable. Sans sortir du cadre de l'invention, le substrat pourrait cependant être déjà coloré, le dépôt du revêtement selon l'invention servant à ce moment à en modifier sa colorimétrie.

La mise en oeuvre d'une cible selon la présente invention pour l'obtention d'un tel vitrage présente plusieurs avantages. Tout d'abord, la coloration se fait de façon totalement indépendante de la fabrication du verre, en particulier pour un verre incolore. Ainsi, on peut fabriquer du verre sans devoir prévoir à l'avance sa coloration. Les couches minces permettent aussi d'obtenir des verres colorés en faible quantité ; le présent procédé est ainsi beaucoup plus adaptable à la demande et flexible. Grâce à la présente invention, Il devient possible d'élaborer des couches de différentes couleurs et en différentes proportions et ceci sans perte intermédiaire de grandes quantités de verre.

Un tel vitrage est susceptible d'être obtenu par la mise en oeuvre d'une cible selon par un procédé de pulvérisation de ladite cible décrit ci-après. Le vitrage comprend un substrat verrier sur lequel est présente une couche, celle-ci étant unique ou alternativement présente au sein d'un empilement de couches, ladite couche étant constituée d'un matériau comprenant des nanoparticules métalliques dispersées dans une matrice inorganique d'un oxyde, lesdites nanoparticules métalliques étant faites dans au moins un métal choisi dans le groupe constitué par l'argent, l'or, le platine, le cuivre et le nickel ou lesdites particules métalliques étant faites dans un alliage constitué d'au moins deux de ces métaux, ladite matrice comprenant un oxyde d'au moins un élément choisi dans le groupe constitué par le titane, le silicium, ou le zirconium ou d'un mélange d'au moins deux de ces éléments, ledit matériau présentant un pic d'absorption plasmonique dans le domaine du visible. Préférentiellement, ladite matrice est constituée essentiellement par ledit oxyde ou est constituée par ledit oxyde.

Le rapport atomique MIMe dans ladite couche est inférieur à 0.9 et dans lequel M représente l'ensemble des atomes desdits éléments du groupe du titane, du silicium, du zirconium présents dans ladite couche et Me représente l'ensemble desdits atomes des métaux du groupe constitué par l'argent, l'or le platine, le cuivre et le nickel présents dans ladite couche.

De préférence, ledit rapport atomique est inférieur à 0,9 voire encore inférieur à 0,8 ou de manière très préférée est inférieur à 0,7.

En particulier dans un tel vitrage :
- Les atomes métalliques Me représentent entre 20 et 50 % des atomes présents dans le matériau constituant la couche, de préférence entre 25 et 45 % des atomes présents dans le matériau constituant la couche et de manière très préférée entre 30 et 40% des atomes présents dans le matériau constituant la couche.
- Les atomes du ou des éléments M représentent ensemble entre 10 et 40 % des atomes présents dans le matériau constituant la couche, de préférence entre 15 et 30 % des atomes présents dans le matériau constituant la couche et de manière très préférée entre 20 et 30 % des atomes présents dans le matériau constituant la couche.
- L'épaisseur de la couche est comprise entre 5 et 100 nm, voire entre 4 et 70 nm, notamment entre 5 et 50 nm et de manière très préférée entre 6 et 20 nanomètres.
- La matrice inorganique est constituée ou constituée essentiellement d'oxyde de titane TiOx, avec 1≤ x ≤2.
- Le métal Me est unique et/ou est l'argent Ag.
- Les nanoparticules métalliques présentent une forme globulaire, notamment sensiblement ronde ou encore oblongue, la plus grande dimension desdites particules, telle que mesurée par Microscopie Electronique en transmission (MET), présentant une moyenne (arithmétique) comprise entre 2 et 20 nanomètres, de préférence comprise entre 4 et 15 nanomètres, de préférence encore comprise entre 4 et 10 nanomètres.
- Les nanoparticules métalliques sont réparties dans la couche selon un gradient croissant de concentration, depuis chaque surface de la couche vers le centre de ladite couche, la concentration en particules d'argent étant maximale sensiblement au centre de la couche.
- Le vitrage comprend en outre au moins une surcouche déposée au-dessus de ladite couche par rapport au substrat verrier, ladite surcouche étant faite dans un matériau diélectrique. Par matériau diélectrique, on entend notamment au sens de la présente description tout matériau dont la résistivité est initialement supérieure à 10¹⁰ ohms-mètres (S2.m) . De tels matériaux peuvent cependant être dopés pour en améliorer la conductivité électrique pour en augmenter leur rendement de pulvérisation cathodique. Par exemple, des couches de Si₃N₄ utilisés dans l'empilement selon l'invention peuvent comprendre de l'aluminium. Selon cette réalisation préférée de l'invention, le dépôt au-dessus de la couche colorée selon l'invention d'une couche de protection en matériau diélectrique permet d'augmenter la durabilité mécanique et/ou chimique dudit revêtement. L'épaisseur de cette couche de protection peut par exemple être de l'ordre de 5 à 50 nm.
- Ledit matériau diélectrique constituant ladite surcouche est constitué essentiellement d'un nitrure de silicium et/ou d'aluminium, en particulier est constitué essentiellement d'un nitrure de silicium, de préférence encore d'épaisseur comprise entre 5 et 50 nm, voire entre 10 et 30 nm.
- Ledit matériau diélectrique constituant ladite surcouche est constitué essentiellement d'un oxyde d'au moins un élément choisi parmi le silicium, le titane, le zinc, l'étain.
- Le vitrage comprend en outre au moins une sous-couche déposée au-dessous de ladite couche par rapport au substrat verrier, ladite sous-couche étant faite dans un matériau diélectrique.
- Ledit matériau diélectrique constituant ladite sous-couche est constituée essentiellement d'un nitrure de silicium et/ou d'aluminium, en particulier est constitué essentiellement d'un nitrure de silicium,
- Ledit matériau diélectrique constituant ladite sous-couche est constitué essentiellement d'un oxyde d'au moins un élément choisi parmi le silicium, le titane, de zinc, l'étain.

La cible selon l'invention trouve particulièrement son application dans des procédés permettant de manière simple et économique d'obtenir des revêtements en couches colorés et qui absorbe le rayonnement visible incident selon une longueur d'onde facilement ajustable, constitués de nanoparticules métalliques entourées d'une matrice diélectrique oxyde.

Selon un premier mode de réalisation, un tel procédé de dépôt d'une couche sur un substrat verrier permettant notamment d'obtenir le vitrage décrit précédemment, comprend une étape dans laquelle on co-pulvérise simultanément par un plasma, dans une même chambre d'un dispositif de dépôt sous vide, deux cibles comprenant de préférence un même oxyde mais dont la composition varie par l'adjonction d'un métal dans la deuxième cible conforme à la présente invention. La couche mince ainsi obtenue comprend des nanoparticules dudit métal ou dudit alliage dispersées dans une matrice inorganique de l'oxyde constitutif des deux cibles, le matériau ainsi constitué présentant notamment un pic d'absorption plasmonique dans le domaine du visible qui confère au vitrage ainsi obtenu une coloration, ladite coloration pouvant également être obtenue au moyen d'une étape de traitement thermique supplémentaire, si nécessaire.

Plus particulièrement, selon un premier mode de réalisation, on utilise la présente cible dans un procédé de dépôt d'une couche d'un matériau présentant un pic d'absorption plasmonique dont le maximum est compris entre 350 et 800 nm sur un substrat verrier, notamment pour la fabrication d'un vitrage tel que décrit précédemment, ledit procédé comprenant au moins les étapes suivantes :
a) on fait défiler ledit substrat dans un dispositif de dépôt sous vide par pulvérisation cathodique,
b) on introduit dans ledit dispositif de dépôt sous vide un gaz plasmagène et on génère un plasma à partir dudit gaz,
c) on pulvérise simultanément, dans une même chambre du dispositif de dépôt sous vide,
   - une première cible comprenant, de préférence constituée essentiellement par, un oxyde d'au moins un élément choisi dans le groupe du titane, du silicium, du zirconium,
   - une seconde cible selon l'invention faite dans un oxyde d'au moins un élément choisi dans le groupe du titane, du silicium, du zirconium et des particules d'un métal compris dans le groupe constitué par l'argent, l'or, le platine, le cuivre et le nickel ou des particules d'un alliage constitué d'au moins deux de ces métaux, ladite cible présentant un rapport atomique MIMe inférieur à 0.9, M représentant l'ensemble des atomes des éléments dudit groupe du titane, du silicium, du zirconium et Me représentant l'ensemble des atomes des métaux du groupe constitué par l'argent, l'or, le platine, le cuivre et le nickel, ladite pulvérisation étant obtenue au moyen dudit plasma,
      ladite pulvérisation étant obtenue au moyen dudit plasma,
d) on récupère un vitrage comprenant ledit substrat recouvert de ladite couche, ladite couche étant constituée de nanoparticules métalliques dudit métal ou dudit alliage dispersées dans une matrice inorganique de l'oxyde et présentant un pic d'absorption plasmonique dans le domaine du visible, ou
d') on récupère un vitrage comprenant ledit substrat recouvert de ladite couche et on traite thermiquement ladite couche, notamment par un traitement tel que décrit dans la demande WO08/096089, dans des conditions adaptées pour obtenir une couche constituée de nanoparticules métalliques dudit métal ou dudit alliage dispersées dans une matrice inorganique de l'oxyde et qui présente un pic d'absorption plasmonique dans le domaine du visible.

Selon des réalisations particulières et préférées d'un tel mode, qui peuvent bien entendues être combinées entre elles :
- Les éléments choisis pour l'oxyde de la première cible et pour l'oxyde de la seconde cible selon l'invention sont identiques.
- l'oxyde de la première cible et de la seconde cible selon l'invention est constitué essentiellement ou est constitué, par un oxyde de titane.

La cible selon l'invention peut également être utilisée selon un second mode de réalisation d'un procédé de dépôt d'une couche d'un matériau présentant un pic d'absorption plasmonique dont le maximum est compris entre 350 et 800 nm sur un substrat verrier, notamment pour la fabrication d'un vitrage tel que décrit précédemment, ledit procédé comprenant au moins les étapes suivantes :
a) on fait défiler ledit substrat dans un dispositif de dépôt sous vide par pulvérisation cathodique,
b) on introduit dans ledit dispositif de dépôt sous vide un gaz plasmagène et on génère un plasma à partir dudit gaz, en présence d'oxygène,
c) on pulvérise dans une chambre dudit dispositif, une cible selon l'invention comprenant un oxyde d'au moins un élément choisi dans le groupe du titane, du silicium, du zirconium, de préférence constituée essentiellement d'un tel oxyde, et de particules d'un métal compris dans le groupe constitué par l'argent, l'or, le platine, le cuivre et le nickel ou des particules d'un alliage constitué d'au moins deux de ces métaux, ladite cible présentant un rapport atomique MIMe inférieur à 0.9, M représentant l'ensemble des atomes des éléments dudit groupe du titane, du silicium, du zirconium et Me représentant l'ensemble des atomes des métaux du groupe constitué par l'argent, l'or, le platine, le cuivre et le nickel, ladite pulvérisation étant obtenue au moyen dudit plasma,
d) on récupère un vitrage comprenant ledit substrat recouvert de ladite couche, ladite couche étant constituée de nanoparticules métalliques dudit métal ou dudit alliage dispersées dans une matrice inorganique de l'oxyde et présentant un pic d'absorption plasmonique dans le domaine du visible,
   ou
d') on récupère un vitrage comprenant ledit substrat recouvert de ladite couche et on traite thermiquement ladite couche dans des conditions adaptées pour obtenir une couche constituée de nanoparticules métalliques dudit métal ou dudit alliage dispersées dans une matrice inorganique de l'oxyde et qui présente un pic d'absorption plasmonique dans le domaine du visible.
   - Selon des réalisations particulières et préférées d'un tel second mode, qui peuvent bien entendues être combinées entre elles : L'oxyde de la cible est constitué essentiellement d'oxyde de titane.
   - le métal est l'argent, l'or ou le platine, de préférence encore l'argent.

De préférence pour ces deux modes de réalisation :
- Le gaz plasmagène est un gaz neutre comprenant essentiellement de l'argon, du krypton ou de l'hélium, seuls ou en mélange.
- Ledit procédé comprend, au cours de l'étape d') un chauffage du substrat jusqu'à une température supérieure à 400°C et inférieure à la température de ramollissement du substrat verrier.

L'étape de chauffage selon l'étape d') est mise en oeuvre selon des conditions de température et pendant le temps nécessaire à l'obtention du pic d'absorption plasmonique, c'est-à-dire à l'obtention de la coloration recherchée de la couche, selon des techniques bien connues de l'homme du métier. Bien évidemment, un tel chauffage peut être effectué sous toute atmosphère convenable à cet effet, en particulier une atmosphère oxydante comme l'air ou alternativement sous une atmosphère d'un gaz neutre ou même sous une atmosphère réductrice.

Ladite coloration est facilement ajustable selon le premier mode de réalisation notamment en modifiant les conditions de ladite pulvérisation et en particulier en agissant sur les puissances appliquées sur les deux cibles.

Selon des réalisations particulières et préférées d'un procédé selon l'un ou l'autre des précédents modes, qui peuvent bien entendues être combinées entre elles :
- Le rapport atomique MIMe dans la cible est inférieur à 0,9, voire est inférieur à 0,8 ou de manière très préférée est inférieur à 0,7, M représentant l'ensemble des atomes des éléments dudit groupe du titane, du silicium, du zirconium présents dans ladite couche et Me représentant l'ensemble des atomes des métaux du groupe constitué par l'argent, l'or le platine, le cuivre et le nickel présents dans ladite couche.
- L'épaisseur de la couche déposée est comprise entre 5 et 100 nm, de préférence entre 6 et 50 nm, de manière très préférée entre 7 et 20 nm.

Egalement, l'invention concerne une installation pour la mise en oeuvre du procédé selon le premier mode décrit précédemment, ladite installation comprenant en combinaison :
- un dispositif de pulvérisation cathodique comprenant au moins une chambre sous vide,
- une première cible telle que décrite précédemment, faite dans un oxyde d'au moins un élément choisi dans le groupe du titane, du silicium, du zirconium,
- une deuxième cible telle que décrite précédemment , faite dans un oxyde d'au moins un élément choisi dans le groupe du titane, du silicium, du zirconium et des particules d'un métal compris dans le groupe constitué par l'argent, l'or, le platine, le cuivre et le nickel ou des particules d'un alliage constitué d'au moins deux de ces métaux,
- des moyens de co-pulvérisation simultanée des deux cibles comprenant des moyens d'introduction d'un gaz plasmagène et des moyens de génération d'un plasma à partir dudit gaz, ledit plasma servant à la pulvérisation desdites cibles,
- des moyens de défilement du substrat dans ledit dispositif, selon une vitesse adaptée pour le dépôt, sur une surface de celui-ci, d'une couche constitué de nanoparticules métalliques dispersées dans une matrice inorganique dudit oxyde,
- des moyens de récupération en sortie du dispositif dudit substrat recouvert dudit revêtement.

Selon le premier mode de réalisation, pour créer le plasma, la cathode, qui peut comprendre deux cibles rotatives ou deux cibles planaires, peut être alimentée par une alimentation RF (radiofréquence) ou une alimentation DC (courant continu), éventuellement pulsé, ou encore une alimentation AC (courant alternatif). De façon connue, une alimentation RF fournit normalement un courant alternatif de 13,56 MHz. L'utilisation de cette alimentation nécessite une boîte d'accord pour accorder le signal généré vers la cible.

En pratique, lorsqu'on cherchera à pulvériser une cible peu ou pas conductrice, on utilisera préférentiellement une alimentation RF.

Selon le procédé de dépôt selon l'invention, il est également possible, voire préféré, d'utiliser une alimentation DC, qui permet d'obtenir un taux supérieur de pulvérisation.

L'invention, ses différents aspects et ses avantages seront mieux compris à la lecture des exemples non limitatifs qui suivent, fournis à titre purement illustratifs.

Dans une première série d'exemples, on cherche à déposer selon le second procédé de l'invention décrit précédemment une couche colorée constituée d'une matrice d'oxyde de l'élément Ti dans laquelle sont dispersées des particules métalliques d'argent sur un substrat verrier incolore. Le verre clair utilisé est commercialisé sous la référence Planiclear^{®} par la société déposante.

Les dépôts des couches colorées selon l'invention sur un substrat verrier sont réalisés dans un bâti de pulvérisation cathodique type magnétron délimitant une chambre dans laquelle un vide secondaire peut être réalisé. Dans ce bâti (constituant l'anode), les cibles (constituant les cathodes) sont installées dans la chambre de telle façon que lors du dépôt, une alimentation RF ou DC permette d'allumer un plasma d'un gaz plasmagène, d'argon, devant lesdites cibles, le substrat défilant parallèlement à cette cible. Il est possible selon cette installation de choisir la vitesse de défilement du substrat et donc le temps de dépôt et l'épaisseur de la couche.

La cible plane selon l'invention est fabriquée à partir d'un mélange d'oxyde de titane et de particules d'argent conformément aux techniques décrites par la suite, de telle façon que son rapport atomique Ti/Ag dans la cible est d'environ 0,5.

On applique sur la cathode la puissance nécessaire à la génération d'un plasma du gaz dans le dispositif. Le dépôt se fait sous atmosphère essentiellement d'argon (gaz neutre plasmagène) et en présence d'une faible portion de dioxygène dans la chambre du bâti. Plus précisément, pour tous les exemples qui suivent, le débit d'argon injecté dans la chambre est initialement de l'ordre de 30 sccm (standard cubic centimeters per minute). Le temps de dépôt est de 60 ou 100 secondes selon les exemples. L'épaisseur des couches ainsi obtenues est de l'ordre de 6 à 9 nm.

Différentes couches sont ainsi déposées selon ces mêmes principes sur plusieurs substrats en verre clair en faisant varier la concentration en oxygène dans le mélange des gaz afin d'obtenir différents échantillons. Ces échantillons sont notés A à D et comprennent une couche constituée d'un oxyde de titane comprenant des nanoparticules d'argent. Le tableau 1 ci-dessous reprend les principaux paramètres de l'étape de dépôt de la couche de revêtement selon le présent procédé.

**Tableau 1**

| Echantillon | substrat | Couche TiOx/Ag | | | | |
|---|---|---|---|---|---|---|
| | | Pression µbar | Puissance sur la cathode (W) | Temps dépôts (s) | Ar (sccm) | Ar/O₂ (sccm) |
| A | verre | 5 | 150 | 100 | 30 | 0 |
| B | verre | 5 | 150 | 60 | 28 | 2 |
| C | verre | 5 | 150 | 60 | 28 | 4 |
| D | verre | 5 | 150 | 100 | 28 | 4 |

Après ce premier dépôt, une surcouche de nitrure de silicium de 30 nanomètres est déposée au-dessus de ladite couche TiOx-Ag dans un autre compartiment de l'installation, selon les techniques classiques connues dans le domaine. Le dépôt au-dessus de la couche colorée selon l'invention d'une couche de protection en matériau diélectrique permet d'augmenter la durabilité mécanique et/ou chimique et/ou thermique dudit revêtement.

Par durabilité mécanique, on entend la résistance aux rayures ou à l'abrasion, par durabilité chimique on entend notamment la résistance à la corrosion au sens de la norme EN1096 citée ci-après. Par durabilité thermique, on entend la stabilité à un ou plusieurs cycles thermiques, par exemple une trempe, un bombage ou un recuit. Après le dépôt, les substrats munis des différents revêtements sont recuits à 650°C sous air pendant 8 mn et à la pression atmosphérique (1 bar).
Pour chaque exemple, les propriétés des revêtements ainsi déposés sont ensuite mesurées selon les protocoles suivants :
Des spectres optiques des échantillons ont été réalisés à l'aide d'un spectrophotomètre Lambda 900 sur la gamme de longueurs d'onde allant de 250 nm à 2500 nm. Des mesures en transmission et en réflexion côté verre et côté couche sont effectuées. On déduit des mesures le spectre d'absorption et l'éventuelle présence d'un pic d'absorption plasmonique dans le visible par la relation suivante : A = 100 - T - R (côté couche), dans lequel A est l'absorption, T est la transmission et R la réflexion.

Les coefficients de transmission et de réflexion lumineuse sont mesurés selon la norme ISO9050 (2003).

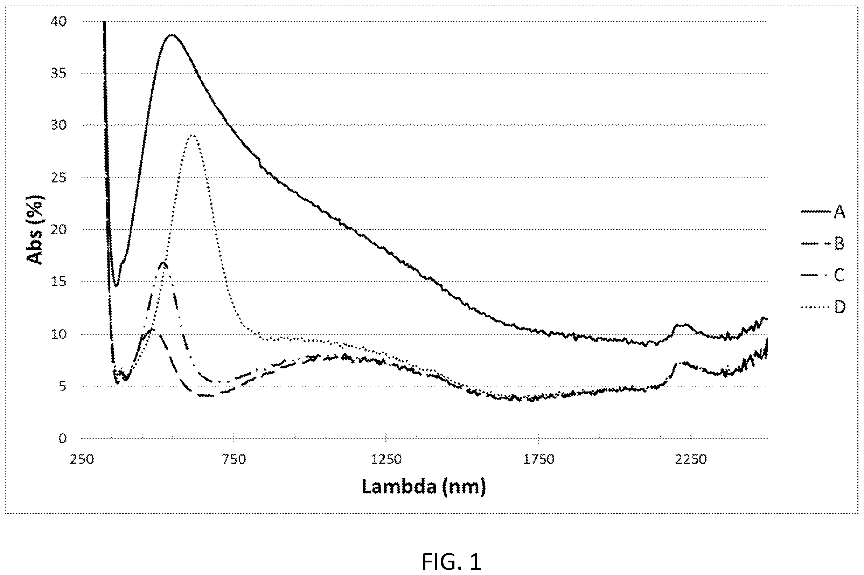

Sur la figure 1 ci-jointe on a reporté les spectres d'absorption dans le visible des vitrages obtenus selon les exemples précédents (longueur d'onde donnée en nanomètres en abscisse).

A partir du spectre obtenu, on détermine les valeurs L*, a* et b* (Système international) qui caractérisent le rendu des couleurs, en transmission et selon l'illuminant D65 (2°).

Pour chacun des exemples, les résultats obtenus sont reportés dans le tableau 2 qui suit.

**Tableau 2**

| **Exemple** | **TL** | **RL (côté couche)** | **RL (côté verre)** | **Colorimétrie** | **Position pic plasmonique** | **Couleur perçue** |
|---|---|---|---|---|---|---|
| A | 50,8 | 11,9 | 19,1 | L* = 76,6 | 550 nm | violet |
| | | | | a* = 2,0 | | |
| | | | | b* = -11,6 | | |
| B | 75,3 | 17,8 | 18,4 | L* = 89,5 | 480 nm | Jaune-Or |
| | | | | a* = 2,1 | | |
| | | | | b* = 2,0 | | |
| C | 70,5 | 16,9 | 18,0 | L* = 87,2 | 520 nm | rose |
| | | | | a* = 5,2 | | |
| | | | | b* = -2,2 | | |
| D | 66,0 | 12,2 | 14,4 | L* = 85 | 610 nm | bleu |
| | | | | a* = -5,7 | | |
| | | | | b* = -7,4 | | |

Les résultats reportés dans le tableau 2 qui précède montrent les avantages liés à la présente invention. En particulier, de façon étonnante et non encore décrite à ce jour, selon un procédé conforme à l'invention, par simple ajustement des conditions opératoires dans lesquelles le dépôt de la couche est effectuée, en particulier de la concentration d'oxygène dans le plasma de pulvérisation de la cible et/ou du temps de dépôt dans la chambre, il est possible selon l'invention de déplacer le pic plasmonique vers une longueur d'onde choisie et d'obtenir au final pour le vitrage la couleur recherchée.

On a analysé la composition chimique de la couche colorée des exemples précédents.
Selon une première série d'analyse, on détermine par microsonde de Castaing (electron probe microanalyser ou EPMA), les compositions des couches selon les exemples A (couleur violette) et D (de couleur bleue).
Les résultats obtenus pour les deux échantillons sont reportés dans le tableau 3 qui suit :

**Tableau 3**

| | Couche Ex. A at. % | Couche Ex. D at.% |
|---|---|---|
| Ag | 34 | 38 |
| O | 44 | 41 |
| Ti | 22 | 21 |
| Ti/Ag | 0,65 | 0,55 |

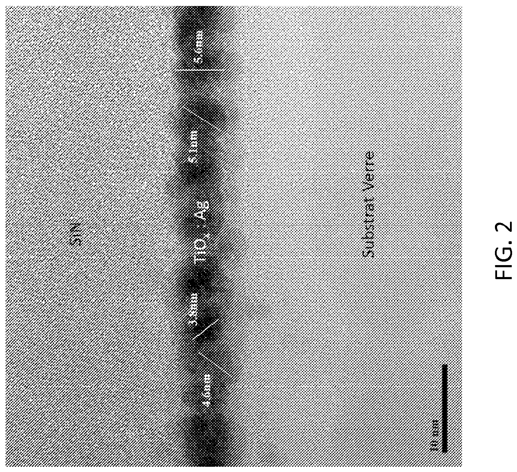

Des analyses en microscopie électronique en transmission (MET) sont également réalisées pour visualiser la morphologie et la répartition des nanoparticules d'argent au sein de la matrice d'oxyde de titane dans les couches colorées selon l'invention. Sur les figures 2 à 5 on a reporté les clichés obtenus en mode champ clair pour les échantillons des exemples A (couche de couleur violette) et D (couche de couleur bleue) décrites précédemment.

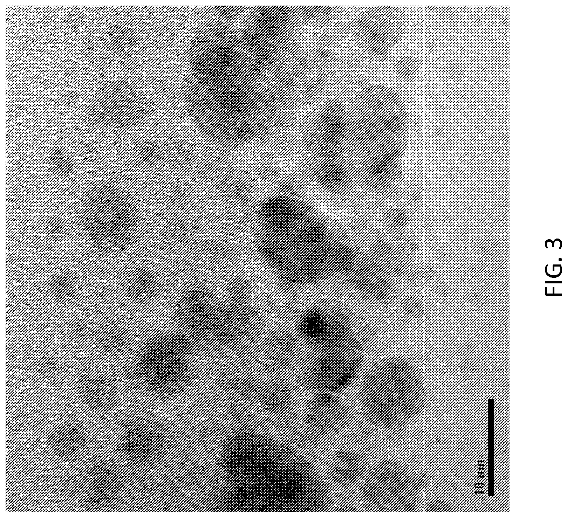

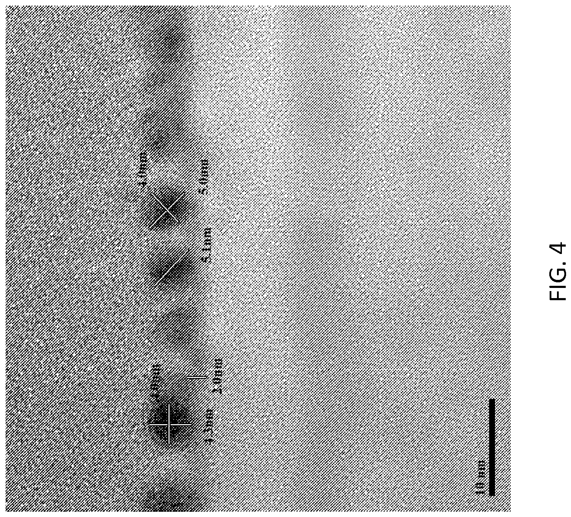

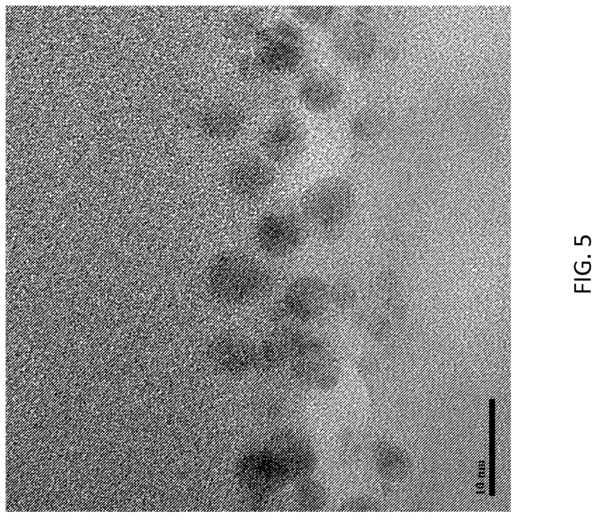

Plus précisément, dans une étape de préparation, un dépôt de carbone d'environ 50 nm d'épaisseur a été réalisé en surface des quatre échantillons. Puis, un dépôt de tungstène par IBID a été réalisé au niveau de la zone de prélèvement lors de la préparation par FIB de la lame mince. Les observations MET (microscopie électronique à transmission) ont été réalisées à l'aide d'un microscope FEI Tecnai Osiris (200keV- SERMA technologies Grenoble) équipé d'un détecteur X-EDS de technologie ChemiSTEM^{™}. Afin de « disperser » sur les clichés obtenus en mode « Champ clair » les particules métalliques et ainsi pouvoir en évaluer les dimensions de manière plus précise, les acquisitions MET ont été réalisées dans un premier temps selon la tranche du vitrage (figures 2 et 4) puis en inclinant le vitrage d'un angle de 15° par rapport au plan de la surface de verre (voir figure 3 et 5).
Plus précisément :
La figure 2 correspond à un cliché MET en champ clair de l'échantillon A (teinte violette) obtenu sans inclinaison.

La figure 3 correspond à un cliché MET en champ clair de l'échantillon A obtenu en inclinant l'axe d'observation de 15° par rapport au plan de la surface du verre.

La figure 4 correspond à un cliché MET en champ clair de l'échantillon D (teinte bleue) obtenu sans inclinaison.

La figure 5 correspond à un cliché MET en champ clair de l'échantillon D obtenu en inclinant l'axe d'observation de 15° par rapport au plan de la surface du verre.

Sur la figure 6 sont reportés les résultats de l'analyse des rayons X dispersive en énergie (X-EDS) de l'échantillon selon l'exemple A.

Les figures 7 et 8 sont des clichés respectivement d'une cible plane et d'une cible tubulaire selon l'invention à partir desquelles le vitrage peut être obtenu.

On observe que des nanoparticules d'argent de forme sensiblement globulaire sont concentrées au sein de la couche (de la matrice). On peut mesurer, comme indiqué sur les figures 2 et 3, les dimensions desdites nanoparticules. Celles-ci présentent, selon leur plus grande dimension et en moyenne, une taille de l'ordre de 3 à 12 nanomètres selon les échantillons.
Le tableau 4 ci-dessous indique les principales caractéristiques des nanoparticules d'argent incluses dans la couche de TiOx, mesurées pour les échantillons A à D selon la technique MET.

**Tableau 4**

| Couche | A | B | C | D |
|---|---|---|---|---|
| Répartition en taille des particules* (nm) | 2 à 10 | 3 à 5 | 5 à 12 | 3 à 6 |
| Taille moyenne des particules* (nm) | 5 | 5 | 8 | 5 |
| Morphologie des particules | ronde | ronde | ovoïde | ronde |

| | | | | |
|---|---|---|---|---|
| *longueur selon leur plus grande dimension | | | | |

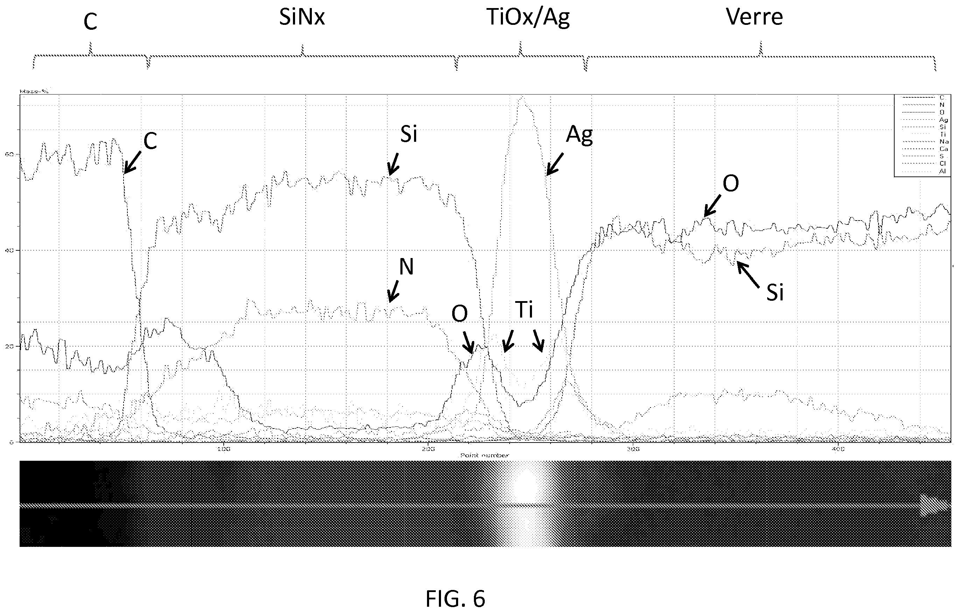

Afin de caractériser plus précisément la répartition des nanoparticules au sein de la couche colorée selon l'invention, on effectue également une analyse des rayons X dispersive en énergie (X-EDS) de l'échantillon selon l'exemple A (teinte violette). La répartition des éléments, telles que reportées sur la figure 6 ci-jointe, montre dans la couche colorée TiOx/Ag une plus forte concentration des nanoparticules d'argent au centre de ladite couche. Cette même répartition caractéristique a été observée sur toutes les couches A à D obtenues selon le procédé selon l'invention.

Dans une deuxième série d'exemples, on cherche à déposer selon le premier procédé selon l'invention décrit précédemment une couche colorée constituée d'une matrice d'oxyde de l'élément Ti dans laquelle sont dispersées des particules métalliques d'argent sur un substrat verrier incolore. Le verre clair utilisé est commercialisé sous la référence Planiclear^{®} par la société déposante.

Les dépôts des couches colorées selon l'invention sur un substrat verrier sont réalisés dans un bâti de pulvérisation cathodique type magnétron délimitant une chambre dans laquelle un vide secondaire peut être réalisé. Dans ce bâti (constituant l'anode), les cibles (constituant les cathodes) sont installées dans la chambre de telle façon que lors du dépôt, une alimentation RF ou DC permette d'allumer un plasma d'un gaz plasmagène, le plus souvent essentiellement de l'argon, du krypton ou de l'hélium, devant lesdites cibles, le substrat défilant parallèlement à cette cible. Il est possible selon cette installation de choisir la vitesse de défilement du substrat et donc le temps de dépôt et l'épaisseur de la couche.

Pour constituer la première cible selon l'invention, on utilise une cible commerciale en oxyde de titane (TiOx).

La deuxième cible, de composition conforme à la présente invention, est fabriquée à partir d'un mélange d'oxyde de titane et de particules d'argent conformément aux techniques décrites dans par la suite.

La deuxième cible selon l'invention est confectionnée de telle façon que le rapport atomique Ti/Ag dans la cible est d'environ 0,5, selon les techniques décrites ci-après.

On applique sur les deux cathodes la puissance nécessaire à la génération d'un plasma du gaz dans le dispositif. Le dépôt se fait sous atmosphère exclusivement d'argon comme gaz neutre plasmagène dans la chambre du bâti. Plus précisément, pour tous les exemples qui suivent, le débit d'argon injecté dans la chambre est de 30 sccm (standard cubic centimeters per minute). Le temps de dépôt est de 200 secondes pour tous les exemples. L'épaisseur des couches ainsi obtenues est de l'ordre de 10 à 15 nm.

Plusieurs couches sont déposées selon ces mêmes principes en faisant varier les puissances appliquées sur les deux cathodes afin d'obtenir différentes matrices diélectriques constituées d'un oxyde de titane comprenant des nanoparticules d'argent présentes en différentes concentrations. Le tableau 1 ci-dessous reprend les principaux paramètres de l'étape de dépôt de la couche de revêtement selon le présent procédé. (les exemple avec un rapport au dessus de 0.9 sont hors invention).

**Tableau 5**

| **Example** | **Argon (sccm)** | **Puissance appliquée sur la cible 1 en TiOx (W)** | **Puissance appliquée sur la cible 2 en TiOx-Ag (W)** | **Temps de dépôt sec** |
|---|---|---|---|---|
| E | 30 | 100 | 100 | 200 |
| F | 30 | 200 | 100 | 200 |
| G | 30 | 300 | 100 | 200 |
| H | 30 | 200 | 0 | 200 |

Des spectres optiques des échantillons ont été réalisés à l'aide d'un spectrophotomètre dans les mêmes conditions que précédemment décrites. Des mesures en transmission et en réflexion côté verre et côté couche sont effectuées pour permettre de retracer un spectre d'absorption. Les positions centrales des pics d'absorption sont reportées dans le tableau 6 qui suit.

**Tableau 6**

| **Exemple** | **Position pic d'absorption** |
|---|---|
| E | 490 nm |
| F | 440 nm |
| G | 420 nm |
| H | - |

On a analysé la composition chimique des couches colorées selon les exemples E à G selon les mêmes méthodes que décrites précédemment. Le rapport molaire Ti/Ag dans les couches varie entre 0,7 à 1,0. (au dessus de 0.9 les exemples sont hors invention).

Afin de caractériser plus précisément la répartition des nanoparticules au sein de la couche colorée selon l'invention, on effectue également une analyse des rayons X dispersive en énergie (X-EDS) des échantillons E à G. Tout comme pour les exemples A à C, la répartition des éléments, montre dans la couche colorée TiOx/Ag une plus forte concentration des nanoparticules d'argent au centre de ladite couche pour les échantillons E à G.
Selon un tel procédé comprenant une étape de co-pulvérisation de deux cibles sur lesquelles on peut faire varier les puissances appliquées, il devient donc possible de faire varier sans difficultés les propriétés optiques de la couche. Notamment, en augmentant la puissance sur la première cible de TiOx, on peut agir immédiatement sur la colorimétrie de la couche déposée et par suite du vitrage. En particulier, il devient possible d'ajuster la concentration des nanoparticules d'Ag dans la couche en fonction de la couleur désirée de la couche et du vitrage.

Au final, selon un procédé selon l'invention, il devient ainsi possible de contrôler parfaitement et de faire varier dans une large gamme la couleur du vitrage de manière très aisée et économique, sans perte de production.

En particulier, par la simple déposition d'une couche de revêtement, il est possible par un tel procédé selon l'invention, par un simple réglage de la puissance appliquée sur les deux cathodes dans le dispositif selon l'invention, de modifier rapidement et sans difficultés et selon une large palette la coloration du vitrage final (substrat recouvert de la couche).

On décrit ci-après certaines caractéristiques particulières de réalisation de la cible selon l'invention. Celle-ci est constituée d'une combinaison d'oxyde de métal M (M représentant l'ensemble des atomes des éléments dudit groupe du Titane, du silicium, du Zirconium) et de métal Me (Me représentant l'ensemble des atomes des métaux du groupe constitué par l'argent, l'or, le platine, le cuivre et le nickel) tel que décrit précédemment. La cible selon l'invention répond en outre de préférence aux critères suivants :
- une répartition homogène des éléments M d'une part et Me d'autre part, de telle sorte qu'aucune hétérogénéité de dispersion de nanoparticules de Me dans la matrice d'oxyde de M dans la couche mince issue de la cible ne soit constatée. Cette homogénéité est requise tant dans la dimension de longueur, de largeur, que d'épaisseur de la cible. La méthodologie et les critères permettant de caractériser l'homogénéité de répartition sont définis ci-après.
- une résistivité électrique compatible avec une utilisation en pulvérisation magnétron AC, RF mais également DC. Pour cela, à titre indicatif, la résistivité de la cible doit être < 5 Ω.cm. Des valeurs supérieures à ce seuil peuvent être considérées, mais la compatibilité avec le mode DC ne sera dans ce cas pas garantie.
- un taux de porosité inférieur à 10%, préférentiellement inférieur à 5% afin de réduire tout risque de formation d'arc électrique (Arcing) pouvant conduire à fondre localement le métal Me de la cible.
Pour atteindre une résistivité électrique optimale et la plus basse possible, il est avantageux de recourir à une formulation légèrement sous-stoechiométrique en oxygène de l'oxyde de métal M lorsque cette forme possède une résistivité électrique inférieure à l'oxyde correspondant. On peut par exemple citer le composé TiOₓ, avec x strictement inférieur à 2. Cependant, ce degré de sous-stoechiométrie est normalement limité à 15% maximum, et préférentiellement 10% maximum afin de limiter l'apport d'oxygène nécessaire ultérieurement dans le magnétron. A titre d'exemple, on cite pour le TiOₓ une valeur de x supérieure ou égale à 2×0,85 soit 1,7, de préférence supérieure à 2×0,9 soit 1,8.

On donne ci-après différents modes de réalisation de la cible selon l'invention :
Selon un premier mode de réalisation possible pour élaborer les cibles selon l'invention, on utilise une technologie de projection thermique, et en particulier de projection plasma, procédé pouvant être mis en oeuvre sous atmosphère d'air ou de gaz neutre. La torche (propulseur) plasma utilisée peut être de type DC ou RF, et les gaz plasmagènes utilisés peuvent être des mélanges binaires de type (A-B) où A = Ar ou N₂ et B = H₂, He, ou N₂ (l'utilisation de N₂ pur étant parmi les combinaisons possibles), ou de mélanges ternaires de type (A-B-C) où A= Ar ; B = N₂ ou H_{2 ;} C = He. Diverses variantes de torches DC à cathode chaude avec stabilisation du plasma par technologie cascade (avec neutrodes), torches DC tri-cathodes, torches DC regroupant 3 plasmas convergents en une tuyère, torches à plasma stabilisé à l'eau peuvent être utilisées comme moyen de construction de la cible.
Les torches à cathode froide de type générateur de plasma thermique entrent également dans le cadre de la présente invention. Ces générateurs utilisent généralement l'air comme gaz plasmagène, mais peuvent aussi fonctionner avec les mélanges binaires ou ternaires cités précédemment.

D'autres modes de projection thermique tels que le procédé HVOF (High Velocity Oxyfuel) ou encore le procédé de Projection Dynamique à Froid (Cold Spray) peuvent aussi être utilisés pour élaborer des cibles selon l'invention.

Le mélange d'alimentation du dispositif de projection peut être en particulier un mélange de particules de métal choisi dans le groupe constitué par l'argent, l'or, le platine, le cuivre, le nickel, de préférence l'Argent, selon une pureté supérieure à 99%, de préférence supérieure à 99,9%, de préférence supérieure à 99,95% poids et des particules d'oxyde d'au moins un élément choisi dans le groupe constitué par le titane, le silicium, le zirconium , de préférence l'élément Ti, ledit oxyde étant sous stoechiométrique en oxygène selon une proportion molaire pouvant aller jusqu'à 15%, préférentiellement jusqu'à 10% afin de limiter l'apport d'oxygène nécessaire ensuite dans le magnétron lors de l'utilisation de la cible.

Selon un autre mode alternatif des particules d'oxyde d'au moins un élément choisi dans le groupe constitué par le titane, le silicium, le zirconium ou d'un alliage constitué d'au moins deux de ces métaux , de préférence de particules de dioxyde de titane (TiO₂), peuvent être mélangées à un bain fondu du métal choisi dans le groupe constitué par l'argent, l'or, le platine, le cuivre, le nickel Me, de préférence un bain d'Argent maintenu en fusion.
Selon un mode particulier, les particules de TiO₂ au contact d'un bain d' 'Argent fondu se réduisent en TiOx. De préférence le rapport atomique Ti/Ag dans la cible est inférieur à 0,5, voire inférieur à 0,4 ou même inférieur à 0,3. Un tel mode alternatif permet, malgré la quantité de métal plus importante, par exemple d'Argent, de limiter les pertes de ce métal par rapport à un procédé de projection de particules d'oxyde de métal M et de particules de métal Me, par exemple d'Argent. Par exemple, une poudre de particules de dioxyde de titane (TiO₂) typiquement de diamètre médian 75 microns, éventuellement préalablement séchée voire préchauffée, peut être projetée, via un gaz vecteur, ou déposée par gravité dans une lingotière d'Argent fondu typiquement à 1000°C.

Un brassage peut être réalisé afin d'obtenir un mélange homogène. Le mélange est maintenu et puis refroidi, par exemple via un dispositif par induction.

Des cibles de forme tubulaire peuvent être réalisées à l'aide de moules avec noyau.

Par exemple, en particulier pour les cibles de forme complexe, y compris les formes tubulaires, le métal fondu peut être maintenu sous fusion localement, par exemple via un dispositif laser dont la longueur d'onde et les paramètres du faisceau peuvent être adaptés au métal employé, tout en apportant concomitamment au voisinage du métal en fusion , par projection, via un gaz vecteur, ou par dépôt gravitaire de la poudre de l'oxyde d'au moins un élément choisi dans le groupe constitué par le titane, le silicium, le zirconium ou d'un alliage constitué d'au moins deux de ces métaux, de préférence du dioxyde de titane, afin d'obtenir un mélange homogène et par conséquent une distribution régulière ou contrôlée des inclusions de métal M partiellement réduit, de préférence de TiOx, après réaction avec le bain de métal fondu.

Pour illustrer l'utilisation de cette famille de procédés pour l'élaboration des cibles selon l'invention, deux exemples de réalisation sont explicités ci-après.

### Selon l'invention:

### Exemple de réalisation n°1 : cible plane avec Me = Ag et M = Ti

Cet exemple de réalisation selon l'invention se rapporte à la réalisation d'une cible plane, constituée d'une combinaison d'oxyde de titane sous-stoechiométrique TiOₓ (avec x = 1,95) et de particules d'argent, les 2 constituants étant répartis dans la microstructure de manière homogène, laquelle cible est destinée à être utilisée en pulvérisation magnétron en mode AC, DC, ou RF.

Cette cible plane TiOₓ-Ag a été élaborée par le procédé de projection plasma décrit précédemment après optimisation de la distribution des différents matériaux dans le jet de plasma. Les étapes principales du procédé sont les suivantes :
- Elaboration de la plaque support intermédiaire (tuile) par usinage, destinée à être brasée ensuite sur le support de cible
- Préparation de surface de la plaque support par projection d'abrasif (Alumine-Zircone AZ grit 24).
- Déposition d'une sous-couche d'accrochage par projection plasma d'un alliage CuAl (90% massique de Cu), d'épaisseur environ 150 µm.
- Pré-mélange de poudres TiOx et Ag dans les proportions calculées en fonction des rendements différentiels (57.3% massique de TiOx et 42.7% massique de poudre d'Ag). Le mélange est agité (en turbula) de manière systématique pendant 1 heure. Les poudres utilisées pour la réalisation de la cible sont des poudres présentant respectivement les caractéristiques suivantes :
∘ Poudre de TiO_{x :} Poudre de type fondue broyée de TiOₓ (x = 1,98) ayant une granulométrie (d₅₀) de 75 µm et une pureté de 99,7%
∘ Poudre d'Argent élaborée par atomisation de métal liquide, une granulométrie (d₅₀) de 45 µm et une pureté de 99,95%

- Construction de la couche active TiOₓ-Ag sur la cible par projection plasma dans les conditions suivantes :
∘ Torche plasma de type DC de puissance maximale 60 kW, placée dans une enceinte sous air
∘ Utilisation de jets refroidisseurs placés sous la plaque support en Cuivre, ainsi que de part et d'autre de la torche plasma, et dirigés vers la cible pour maîtriser la température et les contraintes induites pendant la projection plasma.
∘ Projection plasma menée avec les paramètres suivants :

| Paramètres | Teneur en H₂ (%) | Intensité d'arc (A) | Distance projection (mm) | Débit matière (gr/min) |
|---|---|---|---|---|
| Valeurs utilisées | 13,4 | 450 | 120 | 80 |

∘ Finition de surface par polissage et/ou usinage pour obtention d'une rugosité telle que Ra<5 µm

Un dispositif d'injection du mélange de poudres optimisé permet une injection adaptée dans le plasma sans ségrégation des poudres en vol, permettant d'assurer une répartition homogène de Me et de MO.

Les caractéristiques principales de la cible ainsi produite sont données ci-après:
a. Composition chimique :
L'analyse chimique de la cible ainsi élaborée correspond à un ratio M/Me proche d'environ 0,6.
b. Résistivité électrique :

| | |
|---|---|
| Résistivité volumique mesurée à 20°C par la méthode Van Der Pauw (ASTM F76) | < 100 µΩ.cm |

c. Homogénéité de dispersion de Me dans la structure :

| Critères d'homogénéité sur l'ensemble des ROI | Δ (Max - min) sur teneur moyenne Me | Ecart-type sur teneur moyenne Me |
|---|---|---|
| Cible plane | 44% | 19% |

d. Microstructure et Taux de Porosité

L'évaluation du taux de porosité par analyse d'image, selon la méthode décrite par la suite, est de 1%.

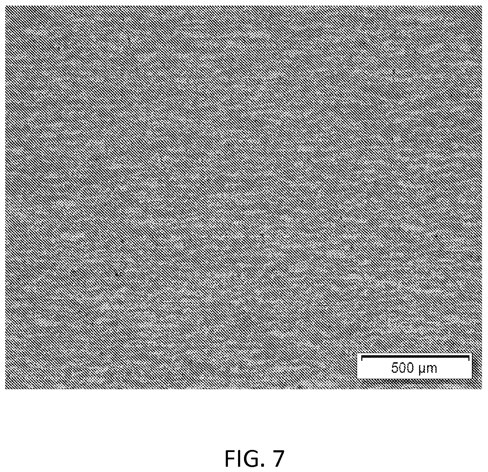

La microstructure de la cible obtenue est illustrée par l'image MEB reportée sur la figure 7 d'une coupe transversale de celle-ci, qui traduit l'excellente homogénéité de répartition des particules d'argent dans l'oxyde de titane.

### Hors invention:

### Exemple de réalisation n°2 : cible tubulaire rotative avec Me = Ag et M = Ti

L'exemple de réalisation concerne une cible tubulaire rotative, constituée d'une combinaison d'oxyde de titane sous-stoechiométrique TiOₓ (avec x = 1,95) et de particules d'Argent, les 2 constituants étant répartis dans la microstructure de manière homogène, laquelle cible est destinée à être utilisée en pulvérisation magnétron en mode AC, DC, ou RF.

Cette cible tubulaire TiOₓ-Ag est élaborée par le procédé de projection plasma après optimisation de la distribution des différents matériaux dans le jet de plasma. Les étapes principales du procédé sont les suivantes :
- Utilisation d'un tube support en acier inox austénitique comme par exemple du X2CrNi18-9.
- Préparation de surface du tube support par projection d'abrasif (Alumine-Zircone AZ grit 24).
- Réalisation d'une sous-couche d'accrochage par le procédé Arc Electrique (Twin Wire Arc Spraying), réalisé sous air, sous-couche d'accrochage de composition NiAl (95% de Nickel), d'épaisseur environ 150-200 µm. Alternativement, les procédés Flamme-Fil (Wire Flame Spray) ou Projection Plasma (Air Plasma Spray) sont également utilisables pour l'obtention de cette sous-couche d'accrochage.
- Pré-mélange de poudres TiOx et Ag dans les proportions calculées en fonction des rendements différentiels (62% massique de TiOx et 38% massique de poudre d'Ag). Le mélange est agité (en turbula) de manière systématique pendant 1 heure.
- Les poudres utilisées pour la réalisation de la cible sont des poudres présentant respectivement les caractéristiques suivantes :
∘ Poudre de TiO_{x :} Poudre de type fondue broyée de TiOₓ (x = 1,98) ayant une granulométrie (d₅₀) de 75 µm et une pureté de 99,7%
∘ Poudre d'Argent élaborée par atomisation de métal liquide, une granulométrie (d₅₀) de 45 µm et une pureté de 99,95%

- Construction de la couche active TiOₓ-Ag sur la cible par projection plasma dans les conditions suivantes :
∘ Torche plasma de type DC de puissance maximale 60 kW, placée dans une enceinte sous air
∘ Utilisation de jets refroidisseurs placés sous la plaque support en Cuivre, ainsi que de part et d'autre de la torche plasma, et dirigés vers la cible pour maîtriser la température et les contraintes induites pendant la projection plasma.
∘ Projection plasma menée avec les paramètres suivants :

| Paramètres | Teneur en H₂ (%) | Intensité d'arc (A) | Distance projection (mm) | Débit matière (gr/min) |
|---|---|---|---|---|
| Valeurs utilisées | 12,3 | 550 | 150 | 160 |

∘ Finition de surface par polissage et/ou usinage pour obtention d'une rugosité telle que Ra<5 µm.

Un dispositif d'injection du mélange de poudres optimisé permet une injection adaptée dans le plasma sans ségrégation des poudres en vol, permettant d'assurer une répartition homogène de Me (Ag) et de MOx (TiOx).

### Caractéristiques essentielles de la cible ainsi produite :

### a. Composition chimique :

L'analyse chimique de la cible ainsi élaborée correspond à un ratio M/Me = 0.92 b. Résistivité électrique :

| | |
|---|---|
| Résistivité volumique mesurée à 20°C par la méthode Van Der Pauw (ASTM F76) | 28,5 µΩ.cm |

### c. Homogénéité de dispersion de Me dans la structure :

| Critères d'homogénéité sur l'ensemble des ROI | Δ (Max - min) sur teneur moyenne Me | Ecart-type sur teneur moyenne Me |
|---|---|---|
| Cible tubulaire | 42% | 24% |

### d. Microstructure et taux de Porosité

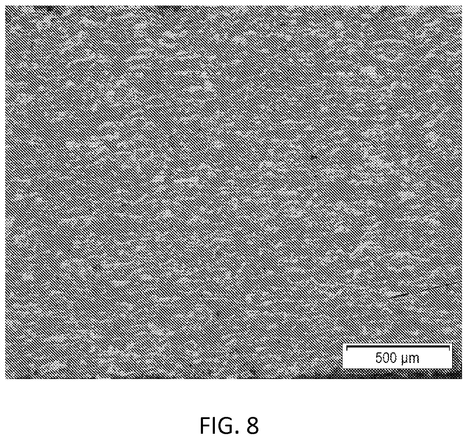

L'évaluation du taux de porosité par analyse d'image, selon la méthode décrite par la suite, est de 1%.
La microstructure de la cible obtenue est illustrée par l'image reportée sur la figure 8 ci-jointe d'une coupe transversale de celle-ci, qui traduit l'excellente homogénéité de répartition de l'argent.

### Exemple de réalisation n°3 : cible formée à partir d'une préforme de TiOx

Selon un troisième mode de réalisation d'un procédé de fabrication d'une cible selon l'invention ne recourant pas à la projection thermique, on réalise les cibles selon l'invention par le procédé décrit ci-après par ses étapes principales visant à l'obtention d'une cible avec M = Ti et Me = Ag et x = 1,8 à 2,0) :

### 1. Réalisation d'une « préforme » de la cible en TiOₓ poreux.

La géométrie des préformes correspond à la géométrie des segments destinés à être fixés sur la plaque support (Backing plate), à savoir des plaques, ou sur le tube support (Backing tube), à savoir des chemises (cylindres creux).
Le taux de porosité recherché pour la préforme est fonction de la teneur volumique finale en TiOₓ visée. Si A% est le taux volumique d'argent visée dans la cible, alors la préforme TiOₓ a un taux de porosité de P% = A%.
Pour des valeurs de porosité élevées, la préforme pourra être par exemple une mousse céramique élaborée selon les techniques de l'art. Alternativement, pour atteindre les niveaux de porosité recherchés, il pourra être éventuellement fait appel à l'addition d'un matériau furtif destiné à agir comme générateur de pores lors du cycle thermique de frittage, ce matériau furtif pouvant être par exemple un polymère). Pour des niveaux de porosités plus faible mais atteignables par frittage classique, la préforme pourra être réalisée par frittage imparfait d'un bloc de poudre pressée.

### 2. Imprégnation de ladite préforme

La préforme poreuse ou mousse céramique est imprégnée d'Ag liquide par l'une des méthodes suivantes :
- Préchauffage de la préforme à 1000°C puis coulage d'Ag liquide sur la préforme disposée dans un boitier (moule) afin de l'imprégner complètement
- Immersion de la préforme (elle-même préchauffée à 1000°C) dans un bain d'Ag liquide puis extraction de la préforme
- Immersion par capillarité en plaçant la préforme au-dessus et au contact du bain d'Ag liquide pour que l'Ag imprègne la préforme par capillarité.

### 3. Fixation sur le support :

Après un léger usinage pour ramener les segments réalisés à la géométrie parfaite visée, les segments préparés sont fixés sur le support (tube ou plaque) par les méthodes de brasage tendre habituellement utilisée pour fixer les cibles magnétron, par exemple la technique de brasage à l'Indium.

Ce troisième mode de réalisation, conduit tel qu'énoncé ici, permettra également d'élaborer la cible selon l'invention avec les caractéristiques répondant aux critères énoncés précédemment (résistivité, homogénéité de répartition de Me, porosité).

On donne ci-après les techniques de mesures permettant de mesurer les caractéristiques essentielles des cibles décrites précédemment :

### A- Méthodologie de caractérisation de l'homogénéité de répartition des phases Oxyde de M et métal Me dans la structure de la cible :

On illustre la méthodologie de caractérisation de l'homogénéité de répartition des phases Oxyde de M d'une part et Métal Me d'autre part, dans le cas particulier d'une cible avec M=Ti et Me=Ag. L'élément M est introduit sous forme d'oxyde de titane sous-stoechiométrique TiOₓ (avec x = 1,95) et l'élément Me sous forme de particules d'argent métallique.
Il s'agit donc de caractériser l'homogénéité de répartition de ces 2 phases en présence.

Pour s'assurer de l'homogénéité de répartition de ces deux phases en présence, un échantillon représentatif de la microstructure de la cible dans son intégralité est analysé selon un protocole d'analyse d'images qui permet de cartographier la présence de Me au sein de la microstructure de l'échantillon. L'échantillon représentatif doit être prélevé dans une zone représentative de la cible, englober la totalité de l'épaisseur de la cible et avoir des dimensions latérales de quelques mm. Le protocole d'analyse s'applique sur des images de la microstructure de la cible en coupe (coupe transversale ou « cross-section »), images prises sur l'échantillon représentatif avec grossissement ×200 voire préférentiellement ×100 afin de couvrir une zone plus vaste.

On définit des zones d'analyse (ou ROI, Région Of Interest) présentant les mêmes surfaces (par exemple 100×100 µm²), idéalement 70×70 µm² et qui sont réparties uniformément sur l'écran d'analyse d'image (voir image 1). Cet écran, doté des définitions des ROIs ainsi réalisées, agira comme une grille d'analyse sur les images de microstructure capturées et présentées face à cette grille. Afin de parcourir ainsi tout l'échantillon de microstructure représentatif de la cible entière, une succession de translations est appliquée pour positionner successivement un nombre suffisant d'images face à la grille d'analyse. Un seuillage sur niveaux de gris peut être appliqué pour détecter la phase métallique Me (plus claire en microscopie optique) et en déterminer la teneur surfacique. L'opération est répétée au moins sur 10 images différentes, prises de la cible en coupe. Ainsi, pour chaque ROI on analysera au minimum 10 images, ce qui permet d'obtenir ainsi la moyenne du pourcentage surfacique de la phase Me par ROI et les écart-types associés.

Une cible ainsi obtenue est considérée comme une structure suffisamment homogène selon l'invention si les conditions suivantes sont remplies :
∘ la différence Δ entre la teneur mesurée en phase Me maximale et la teneur mesurée en phase Me minimale (comptabilisé sur l'ensemble des ROIs choisies aléatoirement) inférieure à 50%, idéalement inférieure à 40% du taux T de phase Me nominal (c'est-à-dire la teneur moyenne en Me observée sur tous les ROI)
∘ de préférence, l'écart-type global calculé sur le nombre total de mesures (=nombre de ROI × nombre d'images) inférieur à 25% du taux T.
Les images obtenues illustrent le positionnement des ROI et la détection de la phase Me est effectuée par seuillage en niveaux de gris.

Cas d'une cible avec une répartition inhomogène :
Pour évaluer la pertinence de ce protocole, des analyses ont été menées en appliquant ce protocole de caractérisation d'homogénéité sur différents essais de réalisation de cibles de type MOx-Me présentant des homogénéités de répartition de Me au sein de MOx très différentes.

Dans le tableau 7 ci-dessous on a reporté les teneurs surfaciques de Me (Argent) par ROI et les écart-types associés, les critères identifiés ci-avant (Δ et Ecart-Types) de telles cibles, qui permettent de traduire l'homogénéité de distribution.

**Tableau 7**

| Critères d'homogénéité sur l'ensemble des ROI | Δ (Max - min) sur teneur moyenne Me | Ecart-type sur teneur moyenne Me |
|---|---|---|
| Echantillon Essai A | 69% | 37% |
| Echantillon Essai B | 121% | 53% |

### B- Mesure du taux de porosité

L'évaluation du taux de porosité est effectuée par les techniques classiques d'analyse d'image à partir de clichés obtenus en microscopie électronique.

Plus précisément, on détermine le taux volumique des porosités contenues dans les cibles à partir de la mesure du taux surfacique de ces porosités par les relations de stéréologie développées par J.C. Russ, R.T Dehoff, «Practical Stereology», 2nd édition, Plenum Press, New York, 1986. Par conséquent, cette section décrit le protocole de mesure du taux surfacique des porosités, déterminé sur images (à grossissement ×100 à ×500) de microstructures de coupes transversales (coupes métallographiques).
L'évaluation de ce taux est effectuée par analyse d'image qui a pour principal objectif de séparer les porosités du reste de la microstructure pour pouvoir effectuer ensuite des mesures sur les caractéristiques des parties sélectionnées.

Plus précisément, l'analyse comporte plusieurs étapes successives à appliquer sur chaque échantillon représentatif de la cible, préalablement poli :
- L'acquisition des images à analyser à partir d'un logiciel d'acquisition, couplé à un ensemble microscope optique et caméra haute résolution. Les images sont préférentiellement prises en niveaux de.
- La sélection de la zone de travail qui définira la surface de l'échantillon sur laquelle va porter les mesures.
- La binarisation de l'image par seuillage qui consiste à ne conserver de l'image initiale que les pixels dont le niveau de gris est compris entre deux seuils prédéterminés. Etant donné que les pixels représentatifs de la porosité sont très foncés, le niveau inférieur peut être choisi égal à 0. Il reste alors à fixer la valeur du seuil supérieur, généralement de manière interactive, en utilisant un histogramme représentatif de la distribution des pixels suivant leur valeur de niveau de gris (de 0, noir à 255, blanc). Les pixels conservés représentatifs de la porosité sont alors codés en noir (0) et les autres en blanc (1) et donnent une image binaire.
- La détermination du taux surfacique des porosités par le rapport de l'aire des pixels codés noirs (0) représentatifs de la porosité sur l'aire de la zone de travail. Cette valeur peut être calculée automatiquement par le logiciel d'analyse d'image.

Le taux moyen de porosité finalement retenu selon l'invention est la valeur moyenne des taux de porosités obtenus sur un nombre suffisant d'images de microstructure prises aléatoirement (5 à 10 images) par la méthode décrite précédemment.

Une cible de pulvérisation cathodique permettant la mise en oeuvre de la présente invention est constituée d'une part d'un oxyde d'au moins un élément choisi dans le groupe du titane, du silicium, du zirconium et d'autre part de particules d'un métal compris dans le groupe constitué par l'argent, l'or, le platine, le cuivre et le nickel ou des particules d'un alliage constitué d'au moins deux de ces métaux, le rapport atomique MIMe dans ladite cible étant inférieur à 0.9, M représentant l'ensemble des atomes des éléments dudit groupe du titane, du silicium, du zirconium présents dans ladite couche et Me représentant l'ensemble des atomes des métaux du groupe constitué par l'argent, l'or le platine, le cuivre et le nickel présents dans ladite couche.

## Revendications

1. Cible de pulvérisation cathodique constituée d'une part d'un oxyde d'au moins un élément choisi dans le groupe du titane, du silicium, du zirconium et d'autre part de particules d'un métal compris dans le groupe constitué par l'argent, l'or, le platine, le cuivre et le nickel ou des particules d'un alliage constitué d'au moins deux de ces métaux, le rapport atomique M/Me dans ladite cible étant inférieur à 0,9, M représentant l'ensemble des atomes des éléments du groupe du titane, du silicium, du zirconium et Me représentant l'ensemble des atomes des métaux du groupe constitué par l'argent, l'or, le platine, le cuivre et le nickel.

2. Cible selon l'une des revendications précédentes dans laquelle le rapport atomique M/Me est inférieur à 0,8.

3. Cible selon l'une des revendications précédentes dans laquelle M représente un unique élément.

4. Cible selon l'une des revendications précédentes dans laquelle ledit oxyde est un oxyde de titane de formule TiOₓ, avec x ≤2.

5. Cible selon l'une des revendications précédentes dans laquelle le métal est l'argent, l'or ou le platine, le cuivre ou le nickel.

6. Cible selon l'une des revendications précédentes dans laquelle le métal est l'argent.

7. Cible selon l'une des revendications précédentes faite dans un mélange d'oxyde de titane et de particules d'argent, le rapport atomique Ti/Ag dans ladite cible étant inférieur à 0,8 ou même inférieur à 0,6.

8. Cible selon l'une des revendications précédentes dans laquelle la résistivité électrique, telle que mesurée selon la norme ASTM F76) est inférieure à 5 Ω.cm.

9. Cible selon l'une des revendications précédentes dans laquelle la répartition de Me par rapport à M est telle que la différence D entre la teneur mesurée dans ladite cible en phase Me maximale et la teneur mesurée dans ladite cible en phase Me minimale, sur une pluralité de zones d'analyse de même surface 70×70 µm², est inférieure à 50%, de préférence inférieure à 40%, de la teneur moyenne en phase Me mesurée sur ladite cible.

10. Cible selon l'une des revendications précédentes dans laquelle l'écart-type global calculé sur le nombre total de mesures est inférieur à 25% de la teneur moyenne en phase Me mesurée sur ladite cible.

11. Procédé de fabrication d'une cible selon l'une des revendications précédentes, comprenant une étape de projection thermique sur un support, en particulier de projection plasma, d'un mélange de l'oxyde d'au moins un élément choisi dans le groupe du titane, du silicium, du zirconium et des particules d'un métal compris dans le groupe constitué par l'argent, l'or, le platine, le cuivre et le nickel ou des particules d'un alliage constitué d'au moins deux de ces métaux.

12. Procédé de fabrication d'une cible selon l'une des revendications 1 à 10, comprenant une étape de mélange de l'oxyde d'au moins un élément choisi dans le groupe du titane, du silicium, du zirconium dans un bain fondu du métal compris dans le groupe constitué par l'argent, l'or, le platine, le cuivre et le nickel ou d'un alliage constitué d'au moins deux de ces métaux et une étape de mise en forme de ladite cible.

13. Procédé de fabrication d'une cible selon la revendication précédente, dans lequel l'étape de mélange comprend la projection ou le dépôt par gravité des particules de l'oxyde d'au moins un élément choisi dans le groupe du titane, du silicium, du zirconium dans le bain de métal fondu.

## Patentansprüche

1. Sputtertarget, das einerseits aus einem Oxid von mindestens einem Element, ausgewählt aus der Gruppe von Titan, Silizium, Zirkonium, und andererseits aus Teilchen eines Metalls, die in der Gruppe von Silber, Gold, Platin, Kupfer und Nickel eingeschlossen sind oder aus Teilchen einer Legierung, bestehend aus mindestens zwei dieser Metalle, besteht, wobei das Atomverhältnis MIMe in dem Target weniger als 0,9 beträgt, wobei M die Gesamtheit der Atome der Elemente der Gruppe von Titan, Silizium, Zirkonium darstellt und Me die Gesamtheit der Atome der Metalle der Gruppe von Silber, Gold, Platin, Kupfer und Nickel darstellt.

2. Target nach einem der vorstehenden Ansprüche, wobei das Atomverhältnis MIMe weniger als 0,8 beträgt.

3. Target nach einem der vorstehenden Ansprüche, wobei M ein einzelnes Element darstellt.

4. Target nach einem der vorstehenden Ansprüche, wobei das Oxid ein Titanoxid der Formel TiOₓ mit x ≤2 ist.

5. Target nach einem der vorstehenden Ansprüche, wobei das Metall Silber, Gold oder Platin, Kupfer oder Nickel ist.

6. Target nach einem der vorstehenden Ansprüche, wobei das Metall Silber ist.

7. Target nach einem der vorstehenden Ansprüche, das aus einer Mischung aus Titanoxid und Silberpartikeln hergestellt ist, wobei das Ti/Ag-Atomverhältnis in dem Target weniger als 0,8 oder sogar weniger als 0,6 beträgt.

8. Target nach einem der vorstehenden Ansprüche, wobei der spezifische elektrische Widerstand, gemessen nach ASTM F76), weniger als 5 Ω.cm beträgt.

9. Target nach einem der vorstehenden Ansprüche, wobei die Verteilung von Me relativ zu M so ist, dass die Differenz D zwischen dem in dem Target in der maximalen Me-Phase gemessenen Gehalt und dem in dem Target in der minimalen Me-Phase gemessenen Gehalt über eine Vielzahl von Analysebereichen mit derselben Oberfläche 70×70 µm² weniger als 50 %, vorzugsweise weniger als 40 %, des durchschnittlichen Me-Phasen-Gehalts beträgt, der auf dem Target gemessen wird.

10. Target nach einem der vorstehenden Ansprüche, wobei die über die Gesamtzahl der Messungen berechnete Gesamtstandardabweichung weniger als 25 % des durchschnittlichen Me-Phasen-Gehalts beträgt, der auf dem Target gemessen wird.

11. Verfahren zum Herstellen eines Targets nach einem der vorstehenden Ansprüche, umfassend einen Schritt des thermischen Spritzens auf einen Träger, insbesondere des Plasmaspritzens, einer Mischung aus dem Oxid von mindestens einem Element, ausgewählt aus der Gruppe von Titan, Silizium, Zirkonium und Teilchen eines Metalls, die in der Gruppe von Silber, Gold, Platin, Kupfer und Nickel eingeschlossen sind, oder Teilchen einer Legierung, bestehend aus mindestens zwei dieser Metalle.

12. Verfahren zum Herstellen eines Targets nach einem der Ansprüche 1 bis 10, umfassend einen Schritt des Mischens des Oxids von mindestens einem Element, ausgewählt aus der Gruppe von Titan, Silizium, Zirkonium, in einem Schmelzbad des Metalls, das in der Gruppe, bestehend aus Silber, Gold, Platin, Kupfer und Nickel eingeschlossen ist, oder einer Legierung, bestehend aus mindestens zwei dieser Metalle, und einen Schritt des Formens des Targets.

13. Verfahren zum Herstellen eines Targets nach dem vorstehenden Anspruch, wobei der Schritt des Mischens das Spritzen oder die Ablagerung durch Schwerkraft der Teilchen des Oxids von mindestens einem Element, ausgewählt aus der Gruppe von Titan, Silizium, Zirkonium, in das Bad des Schmelzguts umfasst.

## Claims

1. A cathode sputtering target formed, on the one hand, from an oxide of at least one element chosen from the group of titanium, silicon and zirconium and, on the other hand, of particles of a metal included in the group formed by silver, gold, platinum, copper and nickel or particles of an alloy formed from at least two of these metals, the M/Me atomic ratio in said target being less than 0.9, M representing all of the atoms of the elements of the group of titanium, silicon and zirconium and Me representing all of the atoms of the metals of the group formed by silver, gold, platinum, copper and nickel.

2. The target as claimed in one of the preceding claims, in which the M/Me atomic ratio is less than 0.8.

3. The target as claimed in one of the preceding claims, in which M represents a single element.

4. The target as claimed in one of the preceding claims, in which said oxide is a titanium oxide of formula TiOₓ with x ≤ 2.

5. The target as claimed in one of the preceding claims, in which the metal is silver, gold, platinum, copper or nickel.

6. The target as claimed in one of the preceding claims, in which the metal is silver.

7. The target as claimed in one of the preceding claims, made from a mixture of titanium oxide and of silver particles, the Ti/Ag atomic ratio in said target being less than 0.8 or even less than 0.6.

8. The target as claimed in one of the preceding claims, in which the electrical resistivity, as measured according to standard ASTM F76), is less than 5 Ω.cm.

9. The target as claimed in one of the preceding claims, in which the distribution of Me relative to M is such that the difference D between the maximum content of Me phase measured in said target and the minimum content of Me phase measured in said target, on a plurality of analysis zones of the same area 70×70 µm², is less than 50%, preferably less than 40%, of the mean content of Me phase measured on said target.

10. The target as claimed in one of the preceding claims, in which the overall standard deviation calculated on the total number of measurements is less than 25% of the mean content of Me phase measured on said target.

11. A process for manufacturing a target as claimed in one of the preceding claims, comprising a step of thermal sputtering onto a support, in particular of plasma sputtering, of a mixture of the oxide of at least one element chosen from the group of titanium, silicon and zirconium and of particles of a metal included in the group formed by silver, gold, platinum, copper and nickel or particles of an alloy formed from at least two of these metals.

12. A process for manufacturing a target as claimed in one of claims 1 to 10, comprising a step of mixing the oxide of at least one element chosen from the group of titanium, silicon and zirconium in a molten bath of the metal included in the group formed by silver, gold, platinum, copper and nickel or an alloy formed from at least two of these metals and a step of forming said target.

13. A process for manufacturing a target as claimed in the preceding claim, in which the mixing step comprises the sputtering or gravity deposition of the particles of the oxide of at least one element chosen from the group of titanium, silicon and zirconium in the bath of molten metal.
